Europäisches Patentamt

European Patent Office

Office européen des brevets

(11) Veröffentlichungsnummer: **0 249 733 B1**

(12) **EUROPÄISCHE PATENTSCHRIFT**

(45) Veröffentlichungstag der Patentschrift: **22.07.92**

(51) Int. Cl.⁵: **H03B 21/02**

(21) Anmeldenummer: **87106623.9**

(22) Anmeldetag: **07.05.87**

(54) **Frequenzsynthetisierer.**

(30) Priorität: **10.06.86 CH 2337/86**
            **08.04.87 CH 1355/87**

(43) Veröffentlichungstag der Anmeldung:
**23.12.87 Patentblatt 87/52**

(45) Bekanntmachung des Hinweises auf die
Patenterteilung:
**22.07.92 Patentblatt 92/30**

(84) Benannte Vertragsstaaten:
**CH DE FR GB IT LI NL SE**

(56) Entgegenhaltungen:
**FR-A- 2 554 292**
**GB-A- 1 037 583**
**US-A- 3 331 035**

**IEEE TRANSACTIONS ON MICROWAVE
THEORY AND TECHNIOUES, Band MTT-30,
Nr. 5, Mai 1982, Seiten 686-693, New York, US;
A.J. BUDREAU et al.: "A review of SAW-
based direct frequency synthesizers"**

(73) Patentinhaber: **SIEMENS-ALBIS AKTIENGE-
SELLSCHAFT
PV/Patente und Verträge Postfach
CH-8047 Zürich(CH)**

(72) Erfinder: **Fognini, Bruno
Am Suteracher 3
CH-8048 Zürich(CH)**

## Beschreibung

Die vorliegende Erfindung betrifft einen Frequenzsynthetisierer nach dem Oberbegriff des Patentanspruches 1.

Aus der Zeitschrift "IEEE Transactions on Microwave Theory and Techniques", Vol. MTT-30, No. 5, Mai 1982, S. 686-693, insbesondere Fig. 9, ist eine Anordnung zur Frequenzsynthese bekannt, bei der verschiedene von einem Hauptoszillator abgeleitete Frequenzen miteinander kombiniert werden. Zu diesem Zweck ist eine Anzahl hintereinandergeschalteter Mischstufen vorgesehen, die je einen Mischer mit einem vorgeschalteten Frequenzteiler benutzen, um zwei von diesen Frequenzen wahlweise zu kombinieren, indem das Ausgangssignal des Mischers jeweils zur nächsten Stufe weitergeleitet wird. Damit können Ausgangssignale mit ausgezeichneter Kurz-und Langzeitstabilität geliefert werden, die zudem eine hohe Frequenzumschaltungsgeschwindigkeit aufweisen.

Eine solche Anordnung erweist sich jedoch als nachteilig im Hinblick auf die Phasenmehrdeutigkeit der Frequenzteiler, die bewirkt, dass bei Frequenzumschaltungen von einer Frequenz fo1 auf eine andere Frequenz fo2 und wieder zurück auf die erste Frequenz das Ausgangssignal nicht mehr phasenkohärent ist.

Der Erfindung liegt daher die Aufgabe zugrunde, bei einer solchen Anordnung ein Ausgangssignal zu erzeugen, das auch bei Frequenzumschaltungen phasenkohärent ist. Diese Aufgabe wird durch die im kennzeichnenden Teil des Patentanspruches 1 dargelegten Massnahmen gelöst. Vorteilhafte Ausgestaltungen der Erfindung sind in weiteren Ansprüchen angegeben.

Die Erfindung wird nachfolgend anhand einer Zeichnung beispielsweise näher erörtert. Es zeigt:

Fig. 1    das Blockschaltbild einer ersten Ausführung eines Frequenzsynthetisierers nach der Erfindung,

Fig. 2    das Blockschaltbild einer zweiten Ausführung eines erfindungsgemässen Frequenzsynthetisierers.

Fig. 3    das Blockschaltbild einer synchonisierbaren Teilerschaltung SD zu einem solchen Frequenzsynthetisierer

Fig. 4    ein Zeitdiagramm verschiedener Signale in einem solchen Frequenzteiler.

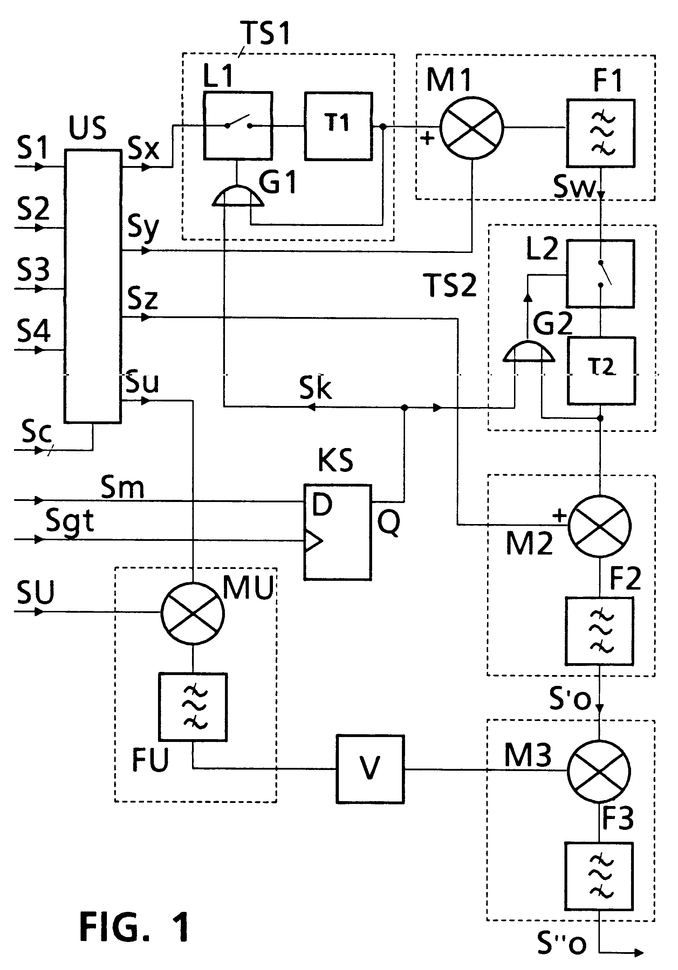

Der Frequenzsynthetisierer nach Fig. 1 umfasst eine Umschalteinrichtung US, zwei Frequenzteilerschaltungen TS1, TS2 und Zwei Mischer M1, M2, denen je ein Filter F1 bzw. F2 nachgeschaltet ist. Die Umschalteinrichtung US weist vier Eingänge für je ein Signal S1, S2, S3, S4 der Frequenz f1, f2, f3 bzw. f4 und drei Ausgänge für je ein Signal Sx, Sy, Sz der Frequenz fx, fy bzw. fz auf. Das Signal Sx wird über die Frequenzteilerschaltung TS1 geführt und im Mischer M1 mit dem Signal Sy gemischt. Das Ausgangssignal Sw des Filters F1 wird über die Frequenzteilerschaltung TS2 geführt und im Mischer M2 mit dem Signal Sz gemischt, wobei eine Frequenzteilerschaltung, ein Mischer und ein Filter jeweils eine Mischstufe bilden. Am Ausgang des Filters F2 erscheint ein Signal S'o der Frequenz f'o, die an sich der Frequenz eines Frequenzsynthetisierers nach dem Stand der Technik entspricht.

Da Hochfrequenzteiler in der Regel nicht zurücksetzbar sind, weisen erfindungsgemäss die Frequenzteilerschaltungen TS1 und TS2 einen durch das Ausgangssignal Sk einer Steuerschaltung KS über ein ODER-Tor G1 bzw. G2 betätigten Schalter L1 bzw. L2 auf, denen ein Frequenzteiler T1 bzw. T2 nachgeschaltet ist. Der andere Eingang des ODER-Tores G1 bzw. G2 Ist mit dem Ausgangssignal des Frequenzteilers T1 bzw. T2 beaufschlagt. Die Schaltung KS kann beispielsweise ein JK- oder D-Flipflop sein, dessen Takteingang mit einem Signal Sgt und dessen Preset-Eingang mit einem Signal Sm beaufschlagt ist, das den Wert "1" aufweist, solange die Codesignale Sc gültig sind, die die Umschalteinrichtung US steuern. Bei einem Uebergang des Signals Sc auf einen anderen Wert ist das Signal 5m = "0". Die Aufgabe der Steuerschaltung KS besteht darin, die Schalter der Schaltungen TS1 und/oder TS2 nicht sofort nach Erscheinen der Signale Sx bzw. Sw, sondern etwas später zu schliessen, und zwar gerade dann und vorzugsweise nur dann, wenn die Signale Sx und Sy eine bestimmte Phasenlage zueinander haben.

Diese bestimmte gegenseitige Phasenlage der Signale Sx und Sy tritt jeweils nach einer Phasenverschiebung des Signales Sx um $k * n * 2\Pi$ Phasen auf. Dabei ist k (k = 1, 2, 3, ...) die Anzahl der mittlerweile abgelaufenen ganzen Perioden des Signals Sgt und n das Verhältnis der Frequenzen fx, fgt (n = fx/fgt), d.h. in einer der k Perioden des Signals Sgt sind jeweils genau n ganze Perioden des Signals fx enthalten. Die Steuerschaltung KS bestimmt daher den jeweils richtigen Zeltpunkt zum Schliessen der Schalter L1 bzw. L2 anhand des Signals Sgt, das aus den vier Signalen S1, S2, S3 und S4 derart abgeleitet wird, dass dessen Frequenz fgt dem grössten gemeinsamen Teiler der Frequenzen dieser vier Signale entspricht; aus den Frequenzen f1 = 220MHz, f2 = 230MHz, f3 = 240MHz, f4 = 250MHZ ergibt sich beispielsweise der Wert fgt = 10MHz. Durch die Wahl des grössten gemeinsamen Teilers ergibt sich die maximale Frequenz für das Signal Sgt, wodurch sich minimale Verzögerungen bei der Umschaltung der Frequenz f'o des Ausgangssignals S'o ergeben.

In weiterer Ausgestaltung der Erfindung kann der beschriebene Teil des erfindungsgemässen Frequenzsynthetisierers nach Fig. 1 derart erweitert werden, dass die Umschalteinrichtung US ein zusätzliches Signal Su liefert, dessen Frequenz fu ebenfalls gleich einer der Frequenzen f1, f2, f3 oder f4 sein kann. Dabei wird in einem zusätzlichen Mischer MU das Signal Su mit einem weiteren Signal SU gemischt und über die Reihenschaltung eines Bandpassfilters FU und eines Frequenzvervielfachers V dem Eingang eines weiteren Mischers M3 zugeführt, der dieses Signal mit dem Ausgangssignal S'o des Filters F2 mischt. Dem Mischer M3 ist ein Bandpassfilter F3 nachgeschaltet, dem das Nutzsignal S"o der Frequenz f"o entnommen wird. Da der erweiterte Frequenzsynthetisierers keine weiteren Frequenzteiler, sondern nur einen Frequenzvervielfacher V aufweist, verliert das Nutzsignal S"o die durch die Steuerschaltung KS gewonnene Phasenkohärenz nicht.

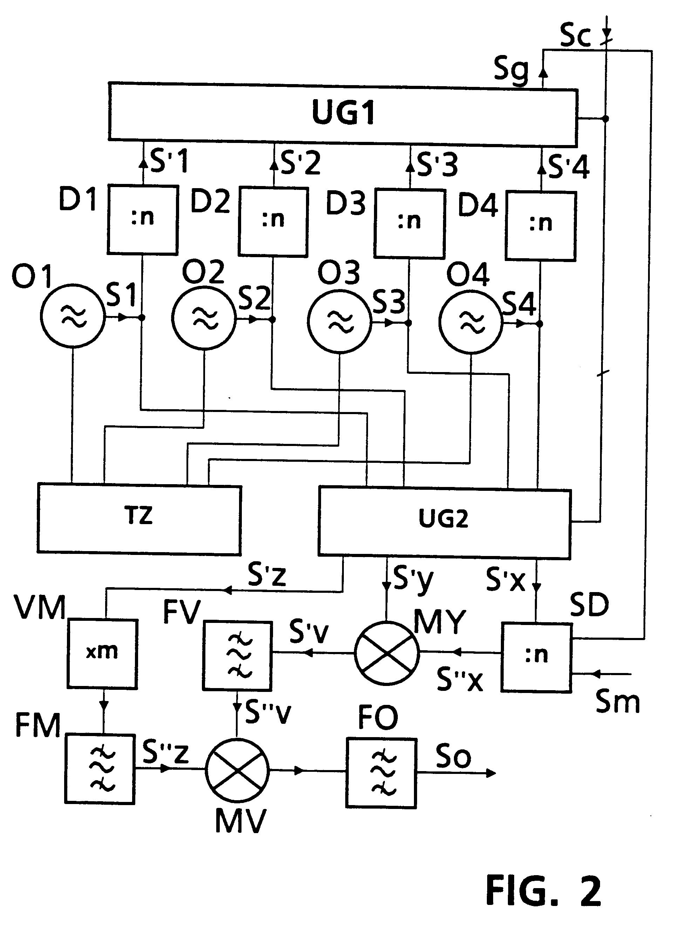

Der Frequenzsynthetisierers nach Fig. 2 umfasst eine aus zwei miteinander verbundenen Umschaltgleidern UG1 und UG2 bestehende Umschalteinrichtung, vier Frequenzteiler D1, D2, D3, D4, einen Frequenzvervielfacher VM mit einem nachgeschalteten Filter FM und zwei Mischer MY und MV, denen je ein Filter FV bzw. FO nachgeschaltet ist. Das Umschaltglied UG2 weist vier Eingänge für je ein Signal S1, S2, S3, S4 der Frequenz f1, f2, f3 bzw. f4 und zwei Ausgänge für je ein Signal S'y, S'z der Frequenz fy, fz auf. Die beispielsweise von je einem Oszillator O1, O2, O3 bzw. O4 erzeugten Signale S1, S2, S3 und S4 werden jeweils über einen der Frequenzteiler D1, D2, D3, D4 je einem Eingang des Umschaltgliedes UG1 zugeführt, das ein Signal Sg der Frequenz f'x liefert. Die vier Oszillatoren O1, O2, O3, O4 werden beispielsweise gemeinsam von einer Taktzentrale TZ synchronisiert. In Fig.2 ist zudem eine fakultativ einsetzbare Frequenzteilerschaltung SD dargestellt, deren Funktion später erläutert wird. Das Ausgangssignal S"x der Frequenzteilerschaltung SD wird mit dem Signal S'y im Mischer MY gemischt, dessen Ausgang über das Filter FV mit dem ersten Eingang des Mischers MV verbunden ist. Das Signal S'z wird über die Elemente VM und FM dem zweiten Eingang des Mischers MV zugeführt, dessen gefiltertes Ausgangssignal So ein phasenkohärentes Nutzsignal ist.

Der Frequenzsynthetisierer nach Fig.2 ohne die Teilerschaltung SD funktioniert folgendermassen:
In diesem Fall sind die Signale Sg und S"x gleich. Die Frequenzen f1, f2, f3, f4 sind vorzugsweise so gewählt, dass die Beziehungen

$$f4 - f3 = f3 - f2 = f2 - f1 = fd$$

gelten. Die Umschaltglieder UG1 und UG2 sind derart beschaffen, dass das Signal Sg wahlweise eines der Signale S'1, S'2, S'3, oder S'4 an den Ausgängen der Teiler D1, D2, D3 bzw. D4 ist und die Signale S'y und S'z wahlweise eines der Signale S1, S2, S3 oder S4 sind. Die Frequenz fo des Signals So am Ausgang des Filters FO ist somit, wenn die Teiler durch n dividieren und der Vervielfacher mit dem Faktor m multipliziert,

$$fo = m.fz + fy + fx$$

Da aber die Bedingungen
fx = fi/n mit i = 1,2,3,4
fy = fj mit j = 1,2,3,4
fz = fk mit k = 1,2,3,4
gelten, ergibt sich fo = m.fk + fj + fi/n. Die zwischen den Signalen S1, S2, S3, S4 vorhandene Phasenstarrheit, die sich auch auf die Signale Sg, S'y, S'z erstreckt, bewirkt, dass das Signal So ebenfalls phasenstarr in bezug auf die Frequenz fo ist, und zwar unabhängig von den gerade gewählten Werten für die Indizes i, j, k, die sich unmittelbar auf die Frequenzen f1, f2, f3 und f4 beziehen. Dieses Ergebnis ist darauf zurückzuführen, dass die Frequenzteiler D1, D2, D3, D4 vor dem Umschaltglied UG1 angeordnet sind und immer mit einem der Signale S1, S2, S3 oder S4 beaufschlagt sind. Die Phasenstarrheit der Signale S1, S2, S3 und S4 untereinander kann auch mit anderen Mitteln, zum Beispiel mit einem einzigen Oszillator und drei oder vier Frequenzteilern oder mit zwei Oszillatoren und zwei Frequenzteilern realisiert werden.

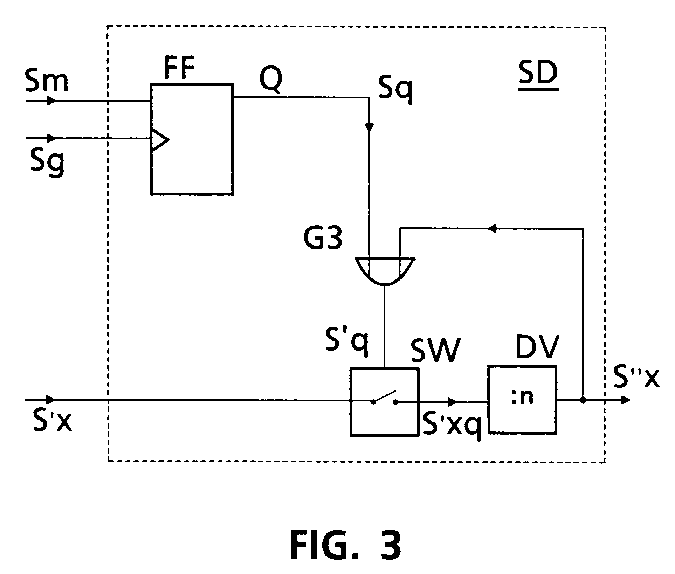

Die synchronisierbare Teilerschaltung SD nach Fig. 3 weist eine Kippstufe FF auf, deren Ausgang Q über ein ODER-Tor G3 mit dem Steuereingang eines Schalters SW verbunden ist, der den Strompfad für ein Signal S'x zum Eingang eines Teilers DV unterbricht, dessen Ausgang mit dem anderen Eingang des Tores G3 verbunden ist. Der Signaleingang der Kippstufe FF ist mit dem Steuersignal Sm und ihr Takteingang mit dem Signal Sg beaufschlagt. Dem Ausgang des Teilers DV ist das Signal S"x entnehmbar.

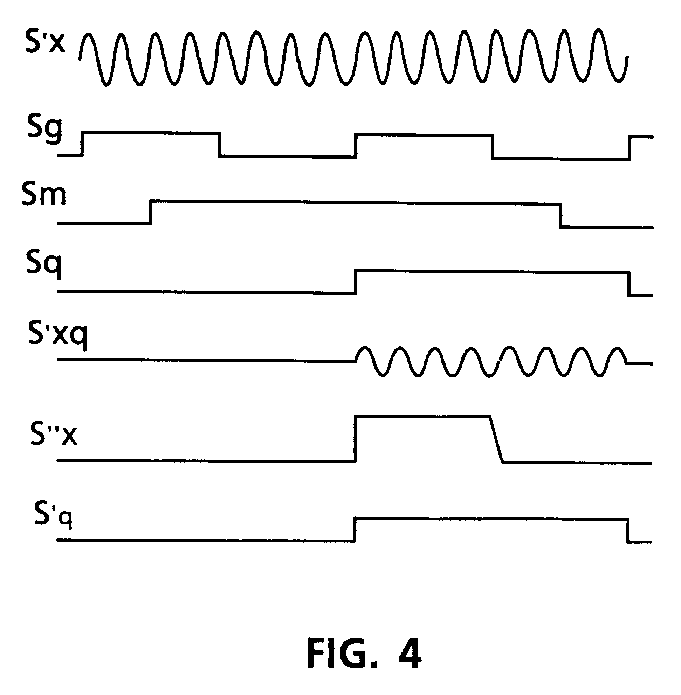

In Fig. 4 sind Zeitdiagramme für die Signale S'x, Sg, Sm und S"x sowie für drei weitere Signale Sq, S'q und S'xq dargestellt. Die Signale Sq bzw. S'q sind die Ausgangssignale der Kippstufe FF (Fig. 3) bzw. des Tores G3. Das Signal S'xq das Eingangssignal des Teilers DV. Der Schalter SW schliesst mit der aktiven Flanke des Signals Sg nach Erscheinen eines Signals Sm mit dem Wert "1".

Der Frequenzsynthetisierer nach Fig. 2, sofern er mit der fakultativen Teilerschaltung SD versehen ist, funktioniert folgendermassen:
Das Umschaltglied UG2 weist in diesem Fall einen zusätzlichen Ausgang für das Signal S'x auf, das somit auch ein durchgeschaltetes Signal der Frequenz f1, f2, f3 oder f4 ist. Dadurch, dass das Signal Sq am Ausgang der Kippstufe FF (Fig. 3) genau mit der aktiven Flanke des Signals Sg (Fig. 4) beginnt, gelangt das Signal S'x genau dann und nur dann zum Teiler DV, wenn ein Vielfaches von n Schwingungen des Signals S'x bereits durchgekommen ist. Somit sind die Signale S'x und S"x immer phasenkohärent, auch wenn zwischendurch das Signal S'x unterbrochen und wieder neu durchgeschaltet wird. Da im weiteren die Signale S'y und S'z auch phasenstarr sind, gilt dies auch für das Signal So Durch den Einsatz der Teilerschaltung SD können gegebenenfalls der Vervielfacher VM und die Elemente FM, MV und FO bei geeigneter Verschiebung der Oszillatorfrequenzen entfallen, was einer weniger aufwendigen Realisierung entspricht. Da im Umschaltglied UG2 normalerweise auch ein Schalter für die Durchschaltung des Signals S'x vorhanden ist, kann dieser Schalter die Funktion des Schalters SW (Fig. 3) übernehmen. In diesem Fall könnte die Teilerschaltung SD ein Teiler üblicher Art sein; das Signal S'q müsste jedoch zusammen mit dem Umschaltcodesignal Sc das Umschaltglied UG2 steuern.

Die Teiler T1 und T2 (Fig. 1) sowie der Teiler` DV (Fig. 3) sind vorzugsweise Teiler, die durch vier dividieren. Ein solcher Teiler besteht aus einer bestimmten Anzahl Flip-Flops, die nicht zurückgesetzt werden können, weil sie keinen Reset-Eingang aufweisen. Bei einem Frequenzwechsel muss der Teiler immer noch so lange aktiv bleiben, bis das Ausgangssignal des Teilers T1, T2 bzw. DV einen konstanten Wert aufweist. Dies wird dadurch erreicht, dass das Signal Sk bzw. Sq mit dem Ausgangssignal des Teilers T1 bzw. T2 bzw. DV durch die ODER-Tore G1, G2 bzw. G3 verknüpft wird. Die Schalter L1, L2 bzw. DV werden somit durch Ausgangssignale der Tore G1, G2 bzw. G3 gesteuert. Somit ist für die Schaltersteuerung beim Einschalten das Signal Sg und beim Ausschalten des Signal S"x bestimmend. Es ist allerdings zu beachten, dass eine zusätzliche Zeitverzögerung eintritt.

Schliesslich sei noch bemerkt, dass die Umschalteinrichtung US nach Fig. 1 und die Umschaltglieder UG1 und UG2 nach Fig. 2 vorzugsweise hochwertige Schaltelemente in Analogtechnik, wie sogenannte 4PST-Schalter, enthalten. Durch den Einsatz der synchronisierbaren Frequenzteilerschaltung SD gemäss Fig. 2 kann jedoch anstelle der hochwertigen Schaltelemente in Analogtechnik ohne weiteres ein handelsüblicher Eins-aus-vier-Demultiplexer für das Umschaltglied UG1 vorgesehen sein.

**Patentansprüche**

1. Frequenzsynthetisierer mit einer Umschalteinrichtung (US; UG1, UG2) und mindestens einer Mischerschaltung (M1, F1; MY, FV), wobei die Umschalteinrichtung eingangsseitig mit wenigstens zwei Signalen (S1, S2), deren Frequenzen (f1 bzw. f2) eine relativ grosse Frequenzkonstanz aufweisen, beaufschlagt wird und ausgangsseitig mindestens zwei über die Umschalteinrichtung durchgeschaltete Signale (Sx, Sy; S'x, S'y) abgibt, deren Frequenzen jeweils gleich einer beliebigen unter den Frequenzen der Eingangssignale sind, wobei wenigstens eines der durchgeschalteten Signale (Sx, S'x), bevor es zur Mischerschaltung (M1, F1; MY, FV) gelangt, derart synchronisiert ist, dass nach dem Ausschalten und Wiedereinschalten eines dieser zu mischenden Signale die ursprüngliche Phasenlage des Mischsignals (Sw; S"v) erhalten bleibt, **dadurch gekennzeichnet,** dass mindestens eine einer Mischerschaltung (M1, F1) vorgeschaltete Frequenzteilerschaltung (TS1; SD) vorhanden ist, die jeweils erst dann wirksam eingeschaltet wird, wenn ihr Eingangssignal (Sx; S'x) eine Verschiebung von $k * n * 2\Pi$ Phasen gegenüber der Phasenlage des Signals im Einschaltzeitpunkt (k = 0) aufweist, worin k die Anzahl abgelaufener Perioden eines Signals (Sgt; Sg) ist, dessen Frequenz fgt ein gemeinsamer Teiler der Frequenzen fx, fy der Signale (Sx, Sy) ist und n das Verhältnis fx/fgt ist, und dass die Frequenzteilerschaltung (TS1; SD) dann und nur dann mittels einer Rückwirkung vom Ausgang auf den Eingang der Frequenzteilerschaltung (TS1; SD) augeschaltet wird, wenn der Ausgang des Teilers (T1; DV) einen definierten logischen Zustand erreicht hat.

2. Frequenzsynthetisierer nach Anspruch 1, **dadurch gekennzeichnet,** dass um diese Phasenstarrheit zu erreichen mindestens ein der Umschalteinrichtung (UG1) vorgeschalteter Frequenzteiler (D1) vorgesehen ist.

3. Frequenzsynthetisierer nach einem der Ansprüche 1 oder 2, **dadurch gekennzeichnet,** dass dem ersten Eingang der Mischerschaltung (MY, FV) ein Frequenzteiler (SD) vorgeschaltet ist, der mittels eines der durchgeschalteten Signale (Sg) wirksam eingeschaltet (k = 1, 2, 3, ...) und durch sein Ausgangssignal (S"x) ausgeschaltet wird.

4. Frequenzsynthetisierer nach einem der Ansprüche 1, 2 oder 3, **dadurch gekennzeichnet,** dass eines der durchgeschalteten Signale (S'z) über einen Frequenzvervielfacher (VM) dem ersten Eingang einer Mischerstufe (MV, FO) zugeführt wird, deren zweiter Eingang mit dem Ausgang der Mischerschaltung (MY, FV) verbunden ist.

## Claims

1.  Frequency synthesizer with a transfer device (US; UG1, UG2) and at least one mixer circuit (M1, F1; MY, FV), whereby the transfer device is loaded on the input side with at least two signals (S1, S2), the frequencies (f1 or f2) of which have a relatively large frequency stability, and on the output side delivers at least two signals (Sx, Sy; S'x, S'y) switched-through via the transfer device, the frequencies of which are in each case the same as any of the frequencies of the input signals, whereby at least one of the switched-through signals (Sx, S'x), before it arrives at the mixer circuit (M1, F1; MY, FV), is synchronized in such a way that after the disconnection and reconnection of one of these signals to be mixed the original phase angle of the mixer signal (Sw; S"v) is retained, characterized in that at least one frequency divider circuit (TS1; SD) connected in series with a mixer circuit (M1, F1) is present, which is in each case only effectively connected if its input signal (Sx; S'x) has a phase displacement of $k * n * 2\Pi$ relative to the phase angle of the signal at the connection instant ($k = 0$), wherein k is the number of occurred periods of a signal (Sgt; Sg), the frequency fgt of which is a common divider of the frequencies fx, fy of the signals (Sx, Sy) and n is the ratio fx/fgt, and that the frequency divider circuit (TS1; SD) is disconnected by means of a reaction from the output to the input of the frequency divider circuit (TS1; SD) when and only when the output of the divider (T1; DV) has reached a defined logical state.

2.  Frequency synthesizer according to claim 1, characterized in that in order to achieve this phase rigidity at least one frequency divider (D1) connected in series with the transfer device (UG1) is provided.

3.  Frequency synthesizer according to one of claims 1 or 2, characterized in that a frequency divider (SD) is connected in series with the first input of the mixer circuit (MY, FV), the frequency divider (SD) being effectively connected by means of one of the switched-through signals (Sg) (k = 1,2,3, ...) and disconnected by means of its output signal (S"x).

4.  Frequency synthesizer according to one of claims 1, 2 or 3, characterized in that one of the switched-through signals (S'z) is supplied via a frequency multiplier (VM) to the first input of a mixer stage (MV, FO), the second input of which is connected to the output of the mixer circuit (MY, FV).

## Revendications

1.  Synthétiseur de fréquence comportant un dispositif de commutation (US; UG1,UG2) et au moins un circuit mélangeur (M1,F1; MY,FV), dans lequel le dispositif de commutation est chargé, côté entrée, par au moins deux signaux (S1,S2), dont les fréquences (f1 ou f2) présentent une constance relativement élevée, et délivre, côté sortie, au moins deux signaux (Sx, Sy; S'x, S'y) transmis par l'intermédiaire du dispositif de commutation et dont les fréquences sont respectivement égales à l'une quelconque des fréquences des signaux d'entrée, au moins l'un des signaux transmis (Sx,S'x) étant synchronisé, avant de parvenir au circuit mélangeur (M1,F1; MY,F2), de manière que la position de phase initiale du signal mixte (Sw; S"v) reste conservée après suppression et nouvelle application de l'un de ces signaux devant être mélangés, caractérisé par le fait qu'il est prévu au moins un circuit diviseur de fréquence (TS1;SD), qui est branché en amont d'un circuit mélangeur (M1,F1) et est rendu actif respectivement uniquement lorsque son signal d'entrée (Sx; S'x) possède un décalage égal à $k*n*2\pi$ phases par rapport à la position de phase du signal à l'instant d'application ($k = 0$), k étant le nombre de périodes écoulées d'un signal (Sgt; Sg) dont la fréquence fgt est un diviseur commun des fréquences fx,fy des signaux (Sx,Sy) et n étant le rapport fx/fgt, et que le circuit diviseur de fréquence (TS1; SD) est désactivé au moyen d'une réaction de la sortie sur l'entrée du circuit diviseur de fréquence (TS1; SD) lorsque et uniquement lorsque la sortie du diviseur (T1; DV) a atteint un état logique défini.

2.  Synthétiseur de fréquence suivant la revendication 1, caractérisé par le fait que pour obtenir ce verrouillage de phase, il est prévu au moins un diviseur de fréquence (D1) branché en amont du dispositif de commutation (UG1).

3.  Synthétiseur de fréquence suivant l'une des revendications 1 ou 2, caractérisé par le fait qu'en amont de la première entrée du circuit mélangeur (MY,FV) est branché un diviseur de fréquence (SD), qui est activé au moyen de l'un des signaux (Sg) transmis (k = 1, 2, 3, ...) et est désactivé par son signal de sortie (S"x).

4.  Synthétiseur de fréquence suivant l'une des revendications 1, 2 ou 3, caractérisé par le fait que l'un des signaux transmis (S'z) est envoyé par l'intermédiaire d'un multiplicateur de fréquence (VM) à la première entrée d'un étage mélangeur (MV, FO), dont la seconde entrée est raccordée à la sortie du circuit mélangeur (MY, FV).

FIG. 1

**FIG. 2**

FIG. 3

S'x

Sg

Sm

Sq

S'xq

S''x

S'q

# FIG. 4